# EUROPEAN PATENT SPECIFICATION

(11) **EP 2 550 676 B1**
(45) Date of publication and mention of the grant of the patent: **22.08.2018**
(21) Application number: 11719371.4
(22) Date of filing: 01.03.2011
(51) Int. Cl.: H01L 23/16

(54) **IC PACKAGE STIFFENER WITH BEAM**
IC-GEHÄUSEVERSTEIFER MIT STREBE
ÉLÉMENT RAIDISSEUR POUR BOÎTIER DE CIRCUIT INTÉGRÉ

(30) Priority: 23.03.2010 US 729882
(43) Date of publication of application: 30.01.2013
(73) Proprietor: Alcatel Lucent, 91620 Nozay (FR)
(72) Inventor: BROWN, Paul, James, Wakefield, Quebec J0X 3G0 (CA); CHAN, Alex, Nepean, Ontario K2J 5K4 (CA)
(74) Representative: Menzietti, Domenico
(86) International application number: PCT/IB2011/000782
(87) International publication number: WO 2011/117726

(56) References cited:
- WO-A2-2004/043130
- US-A- 6 002 171
- US-A- 6 114 761
- US-A1- 2001 009 196
- US-A1- 2008 001 308
- US-A1- 2008 006 926
- US-A1- 2008 042 263
- US-A1- 2009 323 295

## Description

### TECHNICAL FIELD

Various exemplary embodiments disclosed herein relate generally to the field of integrated circuits (IC), and IC packages and their manufacture, and to the field of area array packaging.

### BACKGROUND

A wide variety of semiconductor chips having integrated circuits (IC) are known in the industry. Some examples of IC's include Application Specific Integrated circuits (ASIC) and, Application Specific Standard Product (ASSP). In general, ICs and their packages have been becoming more complex over time, with the result that their power, speed and/or their size has been increasing. Also, ICs are generally attached by having a number of leads that are each individually soldered onto a mounting location of a circuit board or other base component. In some instances, all of these soldered connections may end up not being properly made. This can be particularly true if the IC is not properly flat, since it is generally being mounted to a flat mounting surface.

Warping refers to a bending or twist or general lack of flatness in overall IC package, including particularly the plane formed by the solder joint locations. A lack of flatness in an IC package can cause various problems such as poor soldered joints between the IC package and the mounting surface, poor or no contact at the solder joint, undesirably pillowed joints, or intermittent contact at the solder joints. Lack of flatness can occur where the entire package warps so that it is curved or bent or otherwise non-flat. The desired flatness can in some cases be to a very high tolerance. For example, in some application such as in the context of some BGA packages, a maximum warping tolerance of approx 0.008 inches is desired.

The problem of IC package warping often occurs during the soldering process, also known as reflow, and any re-work of the same. The problem can be exacerbated in larger packages due to the larger size, and is also exacerbated when soldering temperatures become higher. Recently, the use of lead-free solders has become more prevalent and on certain product types. This lead-free solder generally requires a higher soldering temperature than prior solders thus potentially exacerbating IC package warpage.

One prior solution to the problem of IC package warping has been the incorporation on top of the IC of a flat stiffener plate. The stiffener plate takes the form essentially of a completely flat entirely planar item having a constant thickness, and is a simple rectangle having approximately its perimeter be the size of the IC package perimeter when viewed from the top. A central region of the flat stiffener plate may be cut out. However, these stiffener flat plates suffer from the disadvantage that they themselves are entirely flat, and thus, have a somewhat limited resistance to warping due to temperature change or torsion or bending forces. In order to make a flat plate strong enough to provide desirable resistance to warping in the overall IC package, it can be necessary to make the stiffening plate undesirably thick. It is undesirable for the stiffening plate, which rests on top of the IC, to be too thick because the thick stiffening plate, on top of and added to the IC thickness, causes the entire assembled IC package to be thick, thus potentially limiting IC packaging placement options and/or increasing printed circuit card to printed circuit card separation in the final system assembly. Moreover, the added stiffner thickness increases the IC die to lid spacing, thereby creating a larger separation that needs to be filled with Thermal Interface Material, ultimately impeding thermal dissipation from the IC. Moreover, because of the stiffener's entirely flat cross-sectional profile, increased stiffness is achieved inefficiently though the increase of the overall volume of material, thus adding additional cost and weight to the final IC package. Therefore, there is a need in the art for stiffening of IC packages that can provide improved performance and/or mounting reliability while providing a desirable low degree of thickness and/or a desirable low amount of material.

Documents US 2008/0042263 A1 and US 6,114,761 show stiffeners.

### SUMMARY

In light of the present need for stiffening of IC packages that can provide improved performance while providing a desirable low degree of thickness and/or a desirable low amount of material, a brief summary of various embodiments is presented. Some simplifications and omissions may be made in the following summary, which is intended to highlight and introduce some aspects of the various embodiments. Detailed descriptions of a preferred embodiment adequate to allow those of ordinary skill in the art to make and use the inventive concepts will follow in later sections.

The embodiments relate to a stiffener for use with an integrated circuit (IC), or to an IC package including an IC and a stiffener, where the stiffener has a substantially planar portion; and a beam portion connected to the planar portion and projecting at a non-zero angle to the plane in which the planar portion lies.

Some examples relate to a stiffener for use with an integrated circuit (IC), or to an IC package including an IC and a stiffener, where the stiffener forms a frame at least partially surrounding peripheral sides of the IC.

The embodiments enable improved performance and/or mounting reliability. In particular, some embodiments utilize one or more beams in conjunction with a generally planar portion, or one or more beams forming a frame. **BRIEF DESCRIPTION OF THE DRAWINGS**
FIG. 1 is a side cross-sectional diagram of an IC package having a stiffener with side beams according to an example.
FIG. 2 is a side cross-sectional diagram of an IC package having a stiffener with side beams according to another example.
FIG. 3 is a perspective view of the stiffener shown in FIG. 2.
FIG. 4 is a detailed cutaway view of the stiffener shown in FIG. 3.
FIG. 5 is a detailed cut away view of an alternative stiffener with side beams.
FIG. 6 is a detailed cut away view of an alternative stiffener with side beams.
FIG. 7 is a detailed cut away view of an alternative stiffener with side beams.
FIG. 8 is a detailed cut away view of an alternative stiffener with side beams.
FIG. 9 is a perspective view of an alternative stiffener with top beams.
FIG. 10 is a perspective view of an alternative stiffener with a corrugated sheet as a beam according to an embodiment.
FIG. 11 is a perspective view of an example having beams forming a frame surround.
FIG. 12 is a perspective view of an example having beams forming a frame surround and webs forming cross beams.

### DETAILED DESCRIPTION

Referring now to the drawings, in which like numerals refer to like components or steps, there are disclosed broad aspects of examples and embodiments.

The embodiments relate to a stiffener that can be attached to an integrated circuit (IC) package, where the stiffener includes structure dimensioned in a direction other than in the plane of the top of the IC. As used throughout this document, the terms IC (integrated circuit) and IC packaging are used interchangeably to make reference to the overall component assembly, which is also commonly referred to as the IC package. Examples of IC packages include for example TSOPS, QFPs, SOIC, BGA, CCGA, etc. It is noted that above approximately 400 connections, IC packaging almost exclusively take on the form of Area Array style packaging, which itself can include various subtypes, such as for example Column Grid Arrays (CCGA), Pin Grid Arrays (PGA), and Ball Grid Arrays (BGA). The stiffener solutions that are described herein are applicable to such Area Array devices, including for example BGAs. The term IC assembly is used herein to refer to an IC or IC package that has a stiffener incorporated therein or mounted thereto, although the terms IC and IC package can also refer to an item including an IC with a stiffener.

When referring herein to a plane, the reference includes the concept of a flat plate, which actually has a top and bottom flat surface and some thickness, with the top and bottom flat surfaces technically lying along parallel planes. Planar herein includes the concept of a plate being planar although it has such a thickness. In some embodiments described herein, while the stiffener has a flat planar portion, the stiffener can be described as having at least one beam portion with a shape or profile that projects at a non-zero or non-parallel angle to the plane of the top surface of the IC.

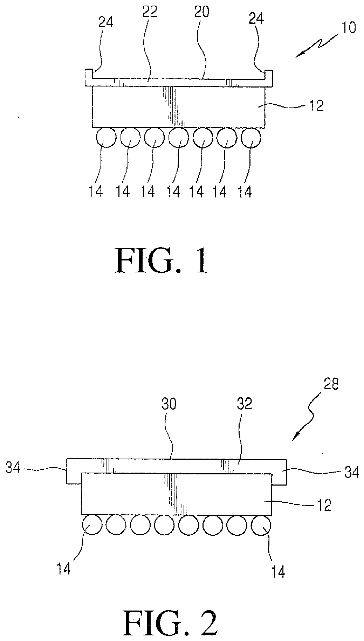

FIG. 1 is a side cross-sectional view through the center of an IC package 10. The IC package 10 includes an IC 12 that is attached to a mounting location, such as a printer circuit board, by plurality of solder joints 14. The IC package 10 includes a stiffener 20 that is affixed to a surface of the IC 12 (in this case, the top surface). The stiffener 20 includes a flat planar portion 22 and elongated beam portions 24, in this instance the beam portions 24 are each a bent portion that projects 90 degrees perpendicular to the plane of the top of the IC 12, and forms a rectangular frame projecting upward at the perimeter of the flat planar portion 22 and parallel to the sides of the IC 12.

FIG. 2 is a side cross-sectional view through the center of an IC package 28. The IC package 28 includes an IC 12 that is attached to a mounting location, such as a printer circuit board, by plurality of solder joints 14. The IC package 28 includes a stiffener 30 that is affixed to a surface of the IC 12 (in this case, the top surface). The stiffener 30 includes a flat planar portion 32 and elongated beam portions 34, in this instance the beam portions 34 are each a bent portion that projects 90 degrees perpendicular to the plane of the top of the IC 12, and forms a rectangular frame projecting downward adjacent the side edge surfaces of the IC 12.

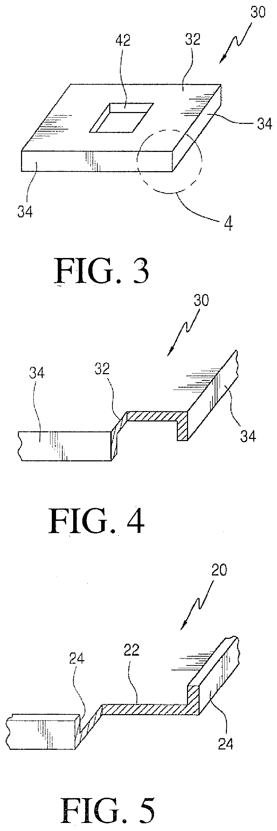

FIG. 3 is a perspective view of the example shown in FIG. 2, and FIG. 4 is a detailed view of the examples shown in FIGS. 2 and 3. The example shown in FIGS. 2 - 4 illustrates a stiffener 30 having a flat portion 32 and a beam portion 34 in the form of a bent projecting portion. In this example, the bent projecting portion 34 projects perpendicular to the plane of the flat portion 32, and extends around the entire periphery of the IC 12. However, in any of the examples herein, the angle of the beam does not need to be limited to a 90 degree or perpendicular angle, and beams that are associated with the sides or edges of the stiffener, or the sides or edges of the IC do not need to form a continuous ring, or be on any or all sides. Also, as shown in FIG. 3, a central aperture 42 provides an opening in a central region of the flat portion 32 of the stiffener 30. The aperture 42 allows a reduction in the use of material as well as in an area for improved heat dissipation.

The provision of a beam combined with a flat portion as in the above-described examples provides for stiffness that resists warping, curving and/or bending that is greater than the stiffness of the flat portion alone. These geometries form an L-Beam shape that is stiffer than a flat plate would be. Also, in examples where the projecting beam portion(s) project downwardly around the outside of the IC, the stiffener can provide high stiffness while having a relatively thin height on top of the IC, particularly in the case of the example of FIGS. 2-4.

The stiffener element can be attached to the IC by any appropriate attachment method. Examples of appropriate attachment mechanisms can include the use of the suitable adhesive and/or some degree of interference fit between the inside of the projecting edge and the outer periphery of the IC. The stiffener may be of any suitable material, examples of which may include metals, plastics, ceramics, or high temperature versions of such materials including high temperature plastics.

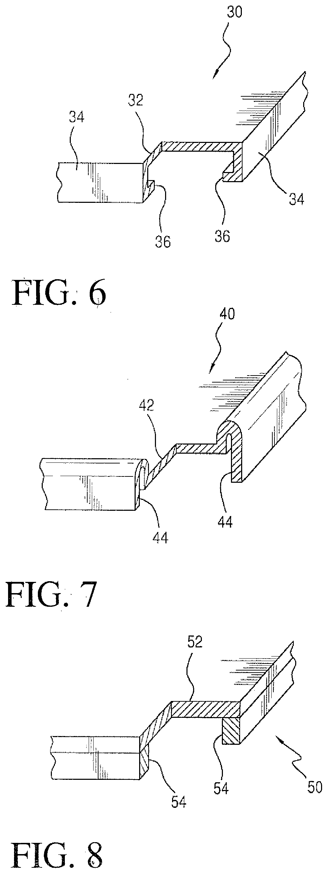

FIG. 5 provides a detailed view similar to FIG. 4, but corresponding to the example of FIG. 1. FIG. 6 shows an alternative profile similar to that of FIG. 4 but including a lip 36 that extends under the IC. FIG. 7 depicts an alternative stiffener 40 having a flat planar portion 42 wherein the beam portion 44 first projects in one direction (upward), then is bent backwards in itself to project in the opposite direction (downward) and around the side of the IC.

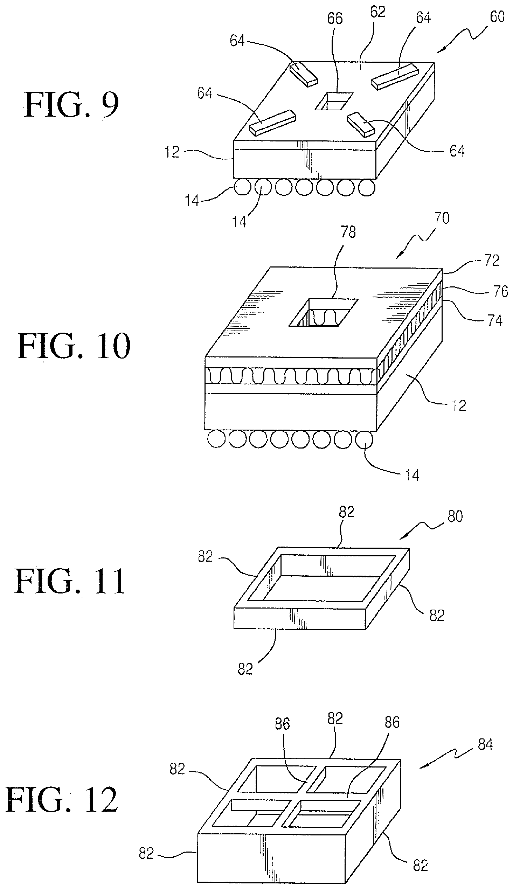

The stiffener can be a monolithic structure, or it can be assembled from a number of discrete structures. For example, the example of FIG. 8 shows an example of a stiffener 50 having a flat planar portion 52 in general having the configuration of the example of FIGS. 2-4, but where the beam portion is a separate beam 54 that has been attached, for example by adhesive or welding, to the flat region. FIG. 9 shows an example of a stiffener 60 with a flat planar portion 62 and where beam elements 64 project upwardly and are also attached by, for example, adhesive or welding. Beam elements such as shown in FIGS. 8 and 9 could be used on or in addition to other beams in the example shown herein. The stiffener 60 also shows an example where a central aperture 66 is provided, and also is illustrated mounted on top of an IC 12 and weld locations 14.

FIG. 10 shows an embodiment of a stiffener 70 having top and bottom flat plates 72 and 74 with beam element(s) 76 interspersed in-between them. In the example shown in FIG. 10, the beam element(s) 76 are formed by a single, corrugated, or wavy-shaped sheet. Besides a corrugated shape, other complex beam shapes may be used including for example a honey combs. Also, the beam elements could take the form of multiple layers such as multiple cross angled corrugation layers. The embodiment shown as stiffener 70 also features a central aperture 78, and is depicted mounted on top of an IC 12 with solder leads 14.

References to beams, beam portions and/or beam elements are interchangeable in this specification. Also such beams can have a wide variety of cross sections including for example L beam, C beam, W beam, I beam, and can incorporate trusses, and also can have relief areas formed into them to reduce their mass. Also references to flat planar portions or flat plates in the detailed description section herein are interchangeable, and such flat portions or plates may include non-flat regions as well, and may have relief areas formed into them to reduce their mass. Various embodiments can have the beams and/or flat portions as integral with each other or as separate pieces attached via any method, such as for example bonding, adhesives, welding or mechanical attachment.

FIG. 11 shows an example of a stiffener 80 which does not utilize a flat plate at all, but includes a peripheral stiffener frame 82 comprised of beams forming a rectangular frame, which extends around the periphery of the IC when mounted to the IC, but does not extend over the top surface of the IC. FIG. 12 depicts an example 84 similar to FIG. 11, but having in addition to the peripheral frame a pair of thin webs 86 forming cross members spanning between top sides of the peripheral frame beams. The webs 84 have a relatively thin height and thus rest on top of the IC but add only their relatively thin height to the resulting IC package.

In examples having a flat portion, the flat portion does not need to cover all of the IC, and besides the example shown in Fig. 3 having a central cut out, the flat portion can cover only one side or the corners or other selected regions of the IC. Further, the projecting portions do not need to project around the entire peripheral of the IC. Therefore, projecting portions could extend over one side, two sides, three sides or all four sides of the IC. For any side where a projecting portion is present, the projecting portion does not need to extend along the entire side, but rather could take the form of one or more projecting portions that project down over only a portion of the IC.

## Claims

1. A stiffener (70) adapted to be affixed to a top surface of an integrated circuit, IC, (12), wherein the stiffener provide added stiffness to the IC (12) to resist warping of the IC (12) during soldering, comprising:
planar portions, which are top flat plates (72) and bottom flat plates (74); and
beam portions (76), which are beam element(s) (76) interspersed in-between the top flat plates (72) and bottom flat plates (74), connected to the planar portions and projecting at a non-zero angle to the planes in which the planar portions lie.

2. A stiffener (70) according to claim 1,
wherein the beam element(s) (76) are formed by a single, corrugated, wavy-shaped sheet, or honey combs beam shapes.

3. A stiffener (70) according to claim 1,
wherein the beam elements (76) take the form of multiple layers, preferably such as multiple cross angled corrugation layers.

4. A stiffener (70) according to claim 1,
wherein the stiffener (70) features a central aperture (78).

5. A stiffener (70) according to claim 1,
wherein the beam elements (76) project upward away from the top portion of the IC (12) when the stiffener (70) is mounted to the IC (12).

6. An integrated circuit, IC, package (10), comprising:
an IC (12); and
a stiffener (70) according to one of the claims 1 to 5 attached to the IC (12).

## Patentansprüche

1. Versteifung (70), ausgelegt zum Anbringen an einer oberen Fläche eines integrierten Schaltkreises, IC, (12),
wobei die Versteifung dem IC (12) zusätzliche Steifheit verleiht, um beim Schweißen dem Verwinden des IC (12) standzuhalten, umfassend:
ebene Teile, bei denen es sich um obere flache Platten (72) handelt und um untere flache Platten (74); und
Balkenteile (76), bei denen es sich um (ein) Balkenelement(e) (76) handelt, die eingestreut sind zwischen die oberen flachen Platten (72) und die unteren flachen Platten (74), die mit den ebenen Teilen verbunden sind und in einem von Null verschiedenen Winkel zu den Ebenen herausragen, in denen die ebenen Teile liegen.

2. Versteifung (70) nach Anspruch 1,
wobei das/die Balkenelement(e) (76) geformt werden durch ein einzelnes, gewelltes, wellenförmiges Blech oder durch Balkenformen im Wabenmuster.

3. Versteifung (70) nach Anspruch 1,
wobei die Balkenelemente (76) die Form mehrerer Schichten annehmen, bevorzugt solche wie mehrfach gekreuzte Wellschichten.

4. Versteifung (70) nach Anspruch 1,
wobei die Versteifung (70) eine zentrale Öffnung (78) aufweist.

5. Versteifung (70) nach Anspruch 1,
wobei die Balkenelemente (76) nach oben weg vom oberen Teil des IC (12) herausragen, wenn die Versteifung (70) an dem IC (12) montiert wird.

6. Integriertes Schaltkreis-, IC, Paket (10), umfassend:
einen IC (12); und
eine Versteifung (70) nach einem beliebigen der Ansprüche 1 bis 5, angebracht an dem IC (12).

## Revendications

1. Élément raidisseur (70) adapté pour être fixé à une surface supérieure d'un circuit intégré, IC, (12),
dans lequel l'élément raidisseur fournit une rigidité supplémentaire à l'IC (12) pour résister à un gauchissement de l'IC (12) pendant le brasage, comprenant :
des portions planaires, qui sont des plaques plates supérieures (72) et des plaques plates inférieures (74) ; et
des portions de poutre (76), qui sont un ou des éléments de poutre (76) interdispersés entre les plaques plates supérieures (72) et les plaques plates inférieures (74), connectés aux portions planaires et faisant saillie à un angle non nul sur les plans dans lesquels les portions planaires se trouvent.

2. Élément raidisseur (70) selon la revendication 1,
dans lequel le ou les éléments de poutre (76) sont formés par une unique feuille de forme ondulée, cannelée, ou des formes de poutres nid d'abeille.

3. Élément raidisseur (70) selon la revendication 1,
dans lequel les éléments de poutre (76) prennent la forme de multiples couches, de préférence telles que de multiples couches à cannelures transversales formant un angle.

4. Élément raidisseur (70) selon la revendication 1,
dans lequel l'élément raidisseur (70) comporte une ouverture centrale (78).

5. Élément raidisseur (70) selon la revendication 1,
dans lequel les éléments de poutre (76) font saillie vers le haut à distance de la portion supérieure de l'IC (12) lorsque l'élément raidisseur (70) est monté sur l'IC (12).

6. Boîtier de circuit intégré, IC, (10), comprenant :
un IC (12) ; et
un élément raidisseur (70) selon l'une des revendications 1 à 5 solidaire de l'IC (12).
